# EUROPEAN PATENT APPLICATION

(11) **EP 1 653 794 A1**
(43) Date of publication of application: **03.05.2006**
(21) Application number: 05077405.8
(22) Date of filing: 19.10.2005
(51) Int. Cl.: H05K 13/08, H05K 1/02, G01N 21/956, G01R 31/309, G06T 7/00

(54) **Technique for optical inspection system verification**

(30) Priority: 27.10.2004 US 974347
(71) Applicant: Delphi Technologies, Inc., Troy, MI 48007 (US)
(72) Inventor: Sanftleben, Henry M., Carmel, MI 46023 (US); Hutchins, Rebecca A., Kokomo, IN 46901 (US); Lawrence, Erin M., Vanwert, OH 45891 (US); Chandler, Brian Lee, Kokomo, IN 46902 (US)
(74) Representative: Denton, Michael John

(57) **Abstract**

A technique (200) for optical inspection verification implements a number of steps. Initially, a simulated solder paste material, including a solder powder and an organic resin, is provided (202). Next, the simulated solder paste material is printed in a desired pattern on a base material (206) to provide a reference test board (101). Then, the test board (101) is cured to stabilize the simulated solder paste material. Next, the test board (101) is utilized to train the optical inspection system to reject defective product.

## Description

### TECHNICAL FIELD

The present invention is generally directed to a technique for optical inspection system verification and, more specifically, to verifying proper operation of an optical inspection system that inspects solder paste deposited upon a printed circuit board.

### BACKGROUND OF THE INVENTION

To date, the proliferation of hand-held and laptop electronic devices, e.g., pagers, cell phones and computers, have resulted in a need for relatively small printed circuit boards (PCBs) with reduced spacing between electronic components mounted to the PCBs. Various industry studies have indicated that approximately fifty percent of all electronics assembly errors and sixty-five percent of service mount technology (SMT) defects are related to solder paste printing and solder joint formation. These studies have generally confirmed that effective and thorough solder paste inspection, immediately after solder paste printing, is desirable to ensure high yields, minimize rework/retest and reduce overall scrap costs of electronic assemblies. According to another study, more than sixty percent of solder defects occur at the solder paste printing stage.

It should be appreciated that when soldering defects are not identified until after a PCB has been populated, costly and time-consuming rework of the PCB is required. Accordingly, various manufacturers have implemented inspection of PCBs immediately following a solder paste printing operation. It should be appreciated that correcting problems at this stage generally only requires cleaning and reprinting the solder paste on the PCB, which is considerably less expensive than repairing the PCB downstream. Further, as the majority of surface mount solder defects result from poor solder paste printing, inspection after solder paste printing offers considerable benefits.

In general, solder paste print inspection systems have included cameras that provide a two-dimensional (2D) view of solder pad coverage and solder paste registration on a PCB. These inspection systems have been utilized to make adjustments and corrections to the solder paste printer, when the printer drifts out of alignment while in use. Other solder paste inspection systems have implemented cameras that have a three-dimensional (3D) capability, which allows the inspection system to estimate solder paste height, based on a single mid-pad measurement. However, this approach may miss flaws, such as dog ears and stencil blockages at the edges of a pad, and exhibit reduced accuracy and have limited repeatability. While automated optical inspection (AOI) systems with optional 3D sensing capability can be utilized for inspection of solder paste, in practice, such systems have not traditionally been implemented. More recently, 3D laser inspection systems have been introduced that allow for 3D solder paste inspection. In general, such 3D inspection systems implement a solid-state scanning laser whose beam is swept back and forth across a PCB under test. One such system implements two position sensitive detectors that allow for solder paste height to be determined by the location of a reflected beam on the detectors.

Typically, solder paste print (deposit) defects can be attributed to stencil misalignment and excessive paste, which leads to bridging, shorts and tombstoning during the mounting of electronic components to an associated PCB. Further, if the solder paste printer runs low on solder paste, or one or more of its apertures are clogged, no paste may be deposited on a pad at which point a component cannot be properly mounted to an associated PCB. Other defects, such as problems with the wetting and the forming of fillets, become noticeable after reflow, even though the source of the problem is the printer.

Unfortunately, a reliable technique to determine if a solder paste inspection system has drifted over time has not been commercially available. Traditionally, human judgment has been utilized to determine whether a solder paste printing operation produced an acceptable solder paste deposition pattern and, if so, the acceptable PCB was then utilized to train the inspection system. However, since solder paste is not a stable material, as printed, and slumps and changes shape with time, the same PCB cannot be utilized over a long period of time to retest the inspection system. Thus, a wider variation in the amount of solder paste printed and being accepted as a good PCB has generally been subject to a wider tolerance, which can result in yield defects and/or reliability issues.

What is needed is a technique for determining if an automatic optical inspection (AOI) system that is utilized to inspect solder paste deposited on a PCB has maintained tolerances over a period of time.

### SUMMARY OF THE INVENTION

The present invention is directed to a technique for optical inspection verification that implements a number of steps. Initially, a simulated solder paste material including a solder powder and an organic resin, is provided. Next, the simulated solder paste material is printed in a desired pattern on a base material, e.g., a printed circuit board (PCB), to provide a reference test board. Then, the test board is cured to stabilize the simulated solder paste material. Next, the test board is utilized to train an optical inspection system to reject defective product. According to another embodiment of the present invention, the desired pattern includes one or more defects. According to a different aspect of the invention, the defects include missing paste, misregistered paste, smeared paste, excessive paste and insufficient paste. According to another aspect of the present invention, the test board is utilized to periodically verify that the optical inspection system is properly functioning.

According to one embodiment of the present invention, a simulated solder paste material includes, by weight, about eighty percent of the solder powder and about twenty percent of the resin. According to another embodiment of the present invention, the resin is an epoxy resin and curative mixture. According to a different aspect of the present invention, the solder paste is substantially invariant after the curing step. According to a different embodiment, the step of utilizing the test board to periodically verify that the optical inspection system is properly functioning further comprises the step of utilizing information acquired during periodic verification to determine the long-term stability of the optical inspection system. The long-term stability of the optical inspection system may be defined by the optical inspection error, drift and bias (as a function of time) and classical statistical process control and measurement system analysis tools may be employed.

These and other features, advantages and objects of the present invention will be further understood and appreciated by those skilled in the art by reference to the following specification, claims and appended drawings.

### BRIEF DESCRIPTION OF THE DRAWINGS

The present invention will now be described, by way of example, with reference to the accompanying drawings, in which:
Fig. 1 is a block diagram of an exemplary PCB assembly line; and
Fig. 2 is a flow chart of a process for creating test boards for periodically verifying proper functioning of an automated optical inspection (AOI) system.

### DESCRIPTION OF THE PREFERRED EMBODIMENTS

According to the present invention, a technique for optical inspection system verification utilizes a simulated solder paste, e.g., a solder powder and an organic resin, which is printed (or stenciled) like solder paste but cures and holds its shape. The simulated solder material is deposited on a base material, e.g., a production printed circuit board (PCB) or ceramic substrate or any substrate material (e.g., flex or laminate, such as FR-4, CEM-1, CEM-2, CEM-3, phenolics, BT and polyimides), and cured. The cured PCB (or reference test board) is then used to periodically verify proper operation of the inspection system. Multiple test boards may be created with some of the test boards having known defects, such as no paste, misregistered paste, smeared paste, excessive paste or insufficient paste. The defective reference test boards may then be used in conjunction with defect-free reference test boards to verify the inspection system is operating correctly. Further, the reference test boards can be utilized to train, test and compare inspection systems located on other manufacturing lines (that manufacture the same product), on-site or off-site at other manufacturing facilities.

The test boards may also be used to periodically re-inspect the inspection system to ensure that the inspection system is functioning consistently with time. It should be appreciated that implementing optical inspection system verification according to the present invention increases the confidence of an electronic assembly manufacturer that the correct amount of solder paste is being deposited onto PCBs from day-to-day and from shift-to-shift and generally helps to reduce variations in the amount of applied solder paste. Thus, according to the present invention, a technique is disclosed that verifies proper operation of an automated optical inspection (AOI) system, which ensures the solder paste is being applied to a PCB in a consistent and repeatable manner. The present invention desirably allows for the application of classical statistical process control (SPC) and measurement system analysis tools to the AOI system.

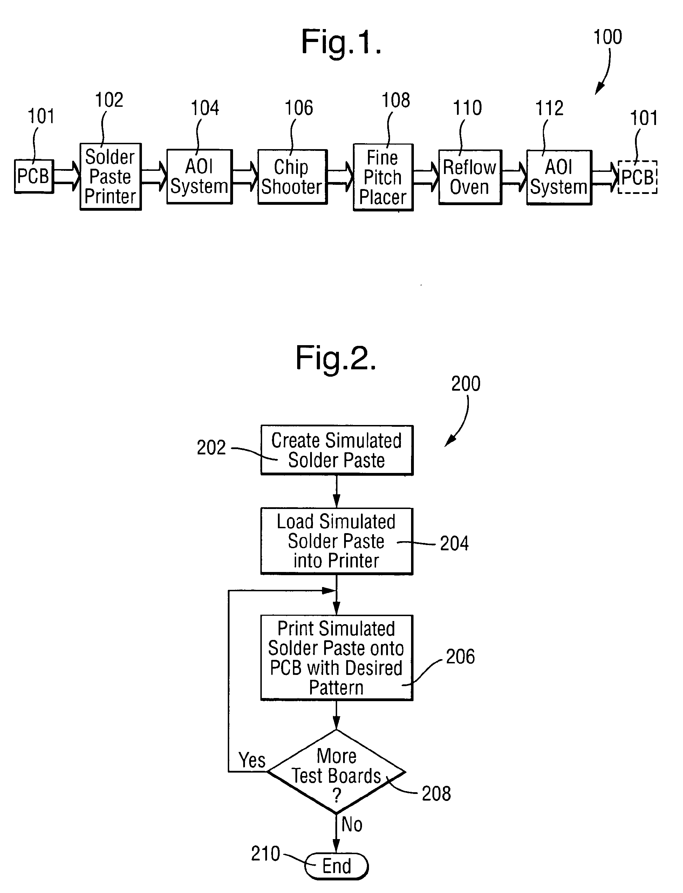

With reference to Fig. 1, an exemplary printed circuit board (PCB) assembly line 100 is depicted. As is shown in Fig. 1, a solder paste printer 102 is utilized to apply a solder paste to a substrate 101, such as a PCB. During the manufacturing process, the substrate 101 (with the applied solder paste) is provided to an automated optical inspection (AOI) system 104, which is utilized to verify that the paste is deposited on the substrate 101 in an appropriate manner. Assuming the substrate 101 passes the inspection process, the substrate 101 is transferred to a chip shooter 106, which is utilized to provide appropriate components, e.g., integrated circuits (ICs), for mounting on the substrate 101. The populated substrate 101 is then supplied to a fine pitch placer 108, which further positions the components on the substrate 101 in an appropriate position. The populated substrate 101 is then supplied to a reflow oven 110, which heats the substrate 101 and its associated components to cause the solder paste to reflow and electrically connect the components to the traces of the substrate 101. The substrate 101 is then supplied to an automated optical inspection (AOI) system 112, which verifies that the substrate 101 has been manufactured according to specification.

As is mentioned above, the AOI system 104, which performs solder paste inspection, has typically been trained using a PCB that has paste deposited in a desired pattern. Unfortunately, as noted above, solder paste is not a stable material, as printed, and slumps and changes with time and, as such, a board with solder paste cannot be utilized over a long period of time to retest the inspection system.

According to the present invention, a reference test board process 200 is implemented that applies a simulated solder paste to a production printed circuit board (PCB) in a desired pattern. The PCB is then utilized as a reference test board, which is used to ensure that the inspection system 104 remains stable over a relatively long period of time, e.g., months to years.

With reference to Fig. 2, the test board process 200 is initiated in step 202, where a simulated solder paste material is created. It is desirable that the simulated solder paste, after a curing step, form a hard and/or permanent matrix. According to one embodiment of the present invention, the simulated solder paste material is made of an organic resin (that cures with time) and a solder powder. For example, the simulated solder paste material may be twenty percent resin (by weight) and eighty percent solder powder (by weight). For example, a two-part epoxy resin and curative, such as Stycast 1265, and a -325 mesh Sn 96.5/Ag 3.5 solder powder may be utilized. The simulated solder paste is manufactured by mixing the epoxy resin parts together and then adding the solder powder until a mixture with solder paste consistency is obtained. The simulated solder paste is then loaded into a solder paste printer in step 204 and printed in step 206 onto a PCB, which provides a reference test board for verifying operation of the AOI system at a later date.

As is previously mentioned, a number of reference test boards may be manufactured. For example, a variety of reference test boards may be manufactured with a number of unacceptable conditions, e.g., missing paste, misregistered paste, smeared paste, insufficient paste and excessive paste. The test boards can then be run through the AOI system (e.g., the system 104) to determine if the system accepts good boards and rejects boards with known defects. In decision step 208, it is determined whether more test boards are to be manufactured and, if so, control transfers to step 206. Otherwise, control transfers to step 210, where the process is terminated. It should be appreciated that it is desirable for the simulated solder paste material to print well and have a visual and optical appearance similar to solder. It is also desirable that the simulated solder paste material have a curing time that is relatively long, e.g., 48 hours at room temperature. However, it should be appreciated that simulated paste materials with curing times greater or less than 48 hours may be utilized.

It should also be appreciated that any number of organic resins can be utilized, depending upon a final desired hardness, the amount of working time, etc. In general, a simulated solder paste material with a longer room temperature cure time will provide a material that has a longer working life. The following epoxy resin formulation provides a material with several hours of room temperature working life: an epoxy resin and curative mixture with 80 parts of a bisphenol-A epoxy resin, e.g., Epon 828 (manufactured and made commercially available by Shell), 20 parts of a flexible aliphatic diepoxide resin based on a polyglycol epoxy resin, e.g., DER 736 (manufactured and made commercially available by Dow Chemical), and 10 parts of an epoxy curative, such as TEDA triethylenediame.

The above description is considered that of the preferred embodiments only. Modifications of the invention will occur to those skilled in the art and to those who make or use the invention. Therefore, it is understood that the embodiments shown in the drawings and described above are merely for illustrative purposes and not intended to limit the scope of the invention, which is defined by the following claims as interpreted according to the principles of patent law, including the doctrine of equivalents.

## Claims

1. A method (200) for optical inspection system verification, comprising the steps of:
providing a simulated solder paste material including a solder powder and an organic resin (202);
printing the simulated solder paste material in a desired pattern on a base material (206) to provide a reference test board (101);
curing the test board (101) to stabilize the simulated solder paste material; and
utilizing the test board (101) to train an optical inspection system to reject defective product.

2. The method (200) of claim 1, wherein the desired pattern includes one or more defects.

3. The method (200) of claim 2, wherein the defects include missing paste, misregistered paste, smeared paste, excessive paste and insufficient paste.

4. The method (200) of claim 1, further comprising the step of:
utilizing the test board (101) to periodically verifying that the optical inspection system is properly functioning.

5. The method (200) of claim 1, wherein the simulated solder paste material includes by weight about eighty percent of the solder powder and about twenty percent of the resin.

6. The method (200) of claim 5, wherein the resin (202) is an epoxy resin and curative mixture.

7. The method (200) of claim 1, wherein the solder paste material is substantially invariant after the curing step.

8. The method (200) of claim 7, wherein the base material is a printed circuit board (PCB) material.

9. The method (200) of claim 8, wherein the PCB material is FR4.

10. The method (200) of claim 4, wherein the step of utilizing the test board (101) to periodically verifying that the optical inspection system is properly functioning further comprises the step of:
utilizing data acquired during periodic verification to determine a long-term stability of the optical inspection system.

11. The method (200) of claim 10, wherein the long-term stability of the optical inspection system is defined by optical inspection error, drift and bias as a function of time.

12. The method (200) of claim 10, further comprising the step of:
utilizing data acquired during periodic verification to at least one of compare and contrast different lines and different sites on the test board (101).

13. A method (200) for optical inspection system verification, comprising the steps of:
providing a simulated solder paste material including a solder powder and an organic resin, wherein the simulated solder paste material includes by weight about eighty percent of the solder powder and about twenty percent of the resin (202);
printing the simulated solder paste material in a desired pattern on a base material (206) to provide a reference test board (101);
curing the test board (101) to stabilize the simulated solder paste material; and
utilizing the test board (101) to train an optical inspection system to reject defective product.

14. The method (200) of claim 13, wherein the desired pattern includes one or more defects.

15. The method (200) of claim 14, wherein the defects include missing paste, misregistered paste, smeared paste, excessive paste and insufficient paste.

16. The method (200) of claim 13, wherein the resin is an epoxy resin and curative mixture.

17. The method (200) of claim 13, wherein the solder paste material is substantially invariant after the curing step.

18. A reference test board (101) for verifying proper operation of an optical inspection system verification, comprising:
a substrate including a plurality of conductive traces; and
a simulated solder paste material formed in a desired pattern on the substrate, the simulated solder paste material including a solder powder and an organic resin, wherein the simulated solder paste material includes by weight about eighty percent of the solder powder and about twenty percent of the resin.

19. The board (101) of claim 18, wherein the desired pattern includes one or more defects.

20. The board (101) of claim 19, wherein the defects include missing paste, misregistered paste, smeared paste, excessive paste and insufficient paste.

21. The board (101) of claim 19, wherein the resin is an epoxy resin and curative mixture.
